# EUROPEAN PATENT APPLICATION

(11) **EP 2 157 832 A1**
(43) Date of publication of application: **24.02.2010**
(21) Application number: 08720455.8
(22) Date of filing: 13.03.2008
(51) Int. Cl.: H05B 33/04, G02F 1/1339, H01L 51/50, H05B 33/10

(54) **ELECTRONIC DEVICE AND METHOD FOR MANUFACTURING THE SAME**

(30) Priority: 29.03.2007 JP 2007088519
(71) Applicant: Fujifilm Corporation, Tokyo 106-8620 (JP)
(72) Inventor: WARASHINA, Hidenaga, Ashigarakami-gun Kanagawa 258-8577 (JP); SHIMOTSU, Shinichi, Ashigarakami-gun Kanagawa 258-8577 (JP); SONODA, Shinichiro, Ashigarakami-gun Kanagawa 258-8577 (JP); GOTO, Chiaki, Ashigarakami-gun Kanagawa 258-8577 (JP)
(74) Representative: Klunker . Schmitt-Nilson . Hirsch
(86) International application number: PCT/JP2008/000569
(87) International publication number: WO 2008/120452

(57) **Abstract**

[Objective]

To manufacture an electronic device while suppressing deterioration of resin substrates and an electronic element to a minimum.

[Constitution]

Low melting point metal layers (7 and 7') are provided to seal electronic elements (3 through 5) between a pair of resin substrates (1 and 1') having barrier layers (2 and 2') laminated thereon, and the barrier layers (2 and 2') are bonded to each other. Light absorbing layers (6 and 6') are provided between the barrier layers (2 and 2') and the low melting point metal layers (7 and 7'). A laser beam having a wavelength within a range from 350nm to 600nm is irradiated onto the light absorbing layer (6) through the resin substrate (1') and the barrier layer (2'), to heat and fuse the low melting point metal layers (7 and 7'), thereby bonding the barrier layers (2 and 2').

## Description

### Technical Field

The present invention is related to an electronic device, in which an electronic element such as a display medium for a liquid crystal display and a light emitting medium for an organic EL device is sealed. The present invention is also related to a manufacturing method for the electronic device.

### Background Art

Typically, flexible display media of flexible displays and electronic paper, and light emitting media such as organic EL's, are of a structure in which an electronic element is sealed between a pair of resin substrates. In the case of a flexible liquid crystal display, for example, the term display medium refers to a liquid crystal layer and an electrode layer. In the case of an organic EL display, for example, the term light emitting medium refers to an organic layer and an electrode layer. The properties of these media generally deteriorate when exposed to moisture. Therefore, barrier coatings are provided on the resin substrates which are employed for the display media, as disclosed in Patent Document 1, to prevent moisture from passing through the substrates and reaching the display media.

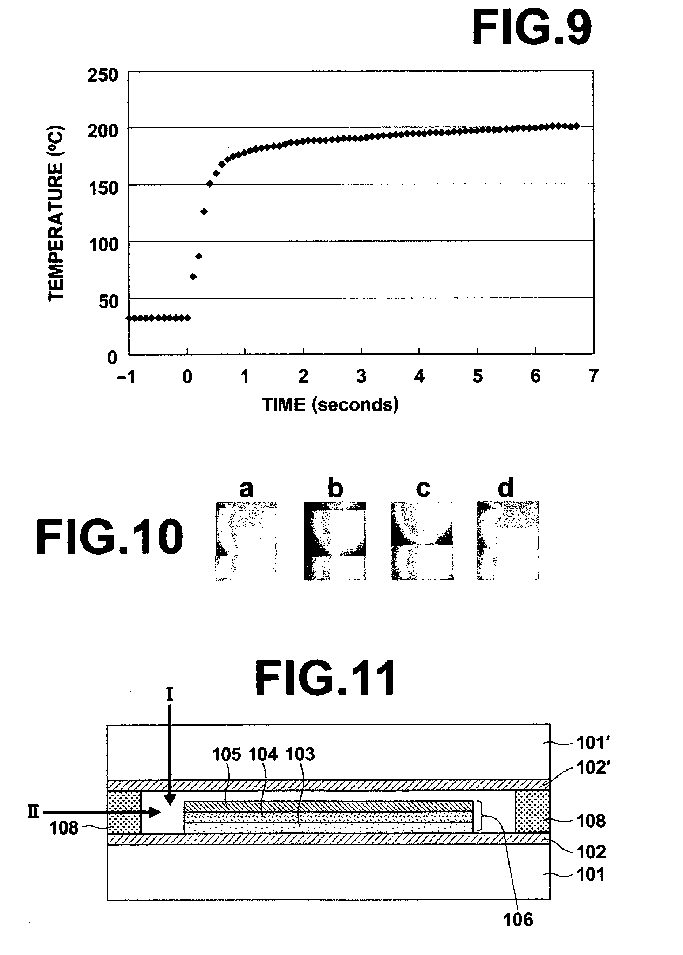

Figure 11 is a schematic sectional view of an organic EL display which has been produced using such substrates. In the organic EL display illustrated in Figure 11, a single layer or a multilayer barrier layer 102 is formed on the upper surface of a transparent lower resin substrate 101. A light emitting medium 106 constituted by a lower transparent electrode 103, an organic layer 104, and an upper electrode layer 105 is formed as a film on the central portion of the barrier layer 102. Among these layers, the organic layer 104 and the upper electrode layer 105 are particularly sensitive with respect to moisture. A barrier layer 102' is also formed on an upper resin substrate 101'. The peripheral portion of the barrier layer 102' is bonded to the peripheral portion on the barrier layer 102 of the lower resin substrate 101 via an adhesive layer 108. Here, passage of moisture practically does not occur in the direction transverse to the barrier layers 102 and 102' (the direction indicated by arrow I). A large part of passage of moisture that influences deterioration of the light emitting medium 106 occurs in the direction that penetrates through the adhesive layer 108 (the direction indicated by arrow II).

From the foregoing, adhesives which have low moisture permeability after curing are suited for use in sealing display media. In addition, resin substrates are generally likely to deform and become altered in properties due to heat application. Further, the properties of light emitting media such as organic EL displays deteriorate in high temperature environments. Therefore, it is desirable for adhesives to be capable of curing at comparatively low temperature.

Photo curable adhesives are capable of curing at temperatures close to room temperature. Therefore, use of such adhesives enables deterioration of substrates and displaymedia due to heat application to be avoided. However, the moisture permeability of photo curable adhesives is high, and those that satisfy the moisture permeability requirements of organic EL displays (1x10⁻⁶g/m²day), for example, are not commercially available. Meanwhile, there are heat curable adhesives that satisfy the above moisture permeability requirements. However, in addition to the aforementioned problems regarding deterioration due to heat application, these adhesives are inferior in flexibility after curing, and have a problem that the flexibility of display media which are produced using such adhesives deteriorates.

Meanwhile, sealing methods that employ low melting point metals such as that disclosed in Patent Document 2 are applied to hermetically seal inorganic materials having high degrees of heat resistance, such as metal and glass. If sealing by these low melting point metals can be administered between the upper and lower barrier layers illustrated in Figure 11, moisture permeation from the exterior can be ideally suppressed, and the reliability of the display element can be improved. However, there are no techniques to date that can fuse low melting point metals interposed between plastic substrates and barrier layers having low heat resistance, without the properties of the plastic substrates and the barrier layers being altered due to heat application.

Patent Document 3 discloses a technique for hermetically sealing an inorganic electroluminescence element using low melting point metals. However, this document is silent regarding the method for heating low melting point metal layers. Generally, the heat resistance properties of inorganic electroluminescence elements are high, and it is possible to heat the entire element to the melting point of low melting point metals. That is, this technique cannot be applied to cases in which the display element is formed on a resin substrate having low heat resistance properties, or in cases that the heat resistance properties of the element itself is low, such as case in which the display elements are organic electroluminescence elements.

Patent Document 4 discloses a technique for sealing a display panel. In this technique, a laser beam is irradiated onto a diffusion preventing layer provided at the periphery of a transparent substrate formed by glass through the transparent substrate. The laser beam which is absorbed by the diffusion preventing layer heats the diffusion preventing layer, and this heat is conducted to a low melting point metal layer which is provided adjacent to the diffusion preventing layer to fuse the low melting point metal layer.
Patent Document 1:
   PCT Japanese Publication No. 2005-528250
Patent Document 2:
   Japanese Patent No. 3091327
Patent Document 3:
   Japanese Patent Publication No. H3-80314
Patent Document 4:
   Japanese Unexamined Patent Publication No. 2004-265837

However, in order to actually implement the process disclosed in Patent Document 4, it is necessary to appropriately adjust parameters such as: the power of the laser beam; the wavelength of the laser beam; the absorption rate of the diffusion preventing layer with respect to the wavelength of the laser beam; the material of the diffusion preventing layer; the thickness of the diffusion preventing layer; the heat capacity of the diffusion preventing layer which depends on the material and thickness thereof; the heat conduction rate to the low melting point metal layer; the thickness of the low melting point metal layer, and the heat capacity of the low melting point metal layer. However, the disclosure of Patent Document 4 does not take any of these parameters into consideration. If the above parameters are not adjusted appropriately, and a laser beam having sufficient power to melt the low melting point metal layer is irradiated, heat damage may occur to the transparent substrate and the diffusion preventing layer. That is, this technique is assumed to be effective for cases in which the heat resistance properties of the transparent substrate are sufficiently high, such as when glass materials are used to form the transparent substrate. However, it is still necessary to develop a sealing method that can maintain the temperatures of transparent substrates and barrier layers at temperatures less than their upper temperature limits during laser irradiation for cases that the transparent substrate is formed by resin, and further for cases that barrier layers are formed on the surface of the resin substrate which is to be sealed.

The present invention has been developed in view of the foregoing circumstances. It is an object of the present invention to provide an electronic device having an electronic element provided between resin substrates with improved anti moisture properties such that deterioration of the electronic element due to moisture can be suppressed. It is another object of the present invention to provide a manufacturing method for an electronic device that suppresses deterioration of resin substrates during the manufacturing process and deterioration of an electronic element to a minimum.

### Disclosure of the Invention

An electronic device of the present invention comprises:
a pair of resin substrates;
barrier layers laminated on each of the pair of resin substrates;
an electronic element formed on one of the barrier layers; and
low melting point metal layers for bonding the pair of resin substrates together, provided at the peripheries of the barrier layers so as to surround the electronic element; characterized by:
a light absorbing layer being provided between at least one of the barrier layers and one of the low melting point metal layers.

Here, the electronic element refers to a display media such as liquid crystals, and light emitting media such as organic EL elements. The electronic device refers to a flexible liquid crystal display, an organic EL display and the like, in which the electronic element is sealed between the resin substrates.

A method for manufacturing an electronic device, in which a low melting point metal layer is provided to seal an electronic element between a pair of resin substrates each having a barrier layer laminated thereon, and the low melting point layer bonds the barrier layers of the resin substrates to each other, of the present invention is characterized by comprising the steps of:
providing a light absorbing layer between at least one of the barrier layers and the low melting point metal layer; and
irradiating a laser beam having a wavelength within a range from 350nm to 600nm onto the light absorbing layer through at least one of the resin substrates and the barrier layer laminated thereon, to heat and fuse the low melting point metal layer, thereby bonding the barrier layers to each other.

The electronic device of the present invention comprises: the pair of resin substrates; the barrier layers laminated on each of the pair of resin substrates; the electronic element formed on one of the barrier layers; and the low melting point metal layers for bonding the pair of resin substrates together, provided at the peripheries of the barrier layers so as to surround the electronic element; and is characterized by: the light absorbing layer being provided between at least one of the barrier layers and one of the low melting point metal layers. Therefore, the anti moisture properties of the electronic element are improved, and deterioration of the electronic element due to moisture can be suppressed.

The method for manufacturing an electronic device of the present invention is that for manufacturing an electronic device, in which a low melting point metal layer is provided to seal an electronic element between a pair of resin substrates each having a barrier layer laminated thereon, and the low melting point layer bonds the barrier layers of the resin substrates to each other, and is characterized by comprising the steps of: providing a light absorbing layer between at least one of the barrier layers and the low melting point metal layer; and irradiating a laser beam having a wavelength within a range from 350nm to 600nm onto the light absorbing layer through at least one of the resin substrates and the barrier layer laminated thereon, to heat and fuse the low melting point metal layer, thereby bonding the barrier layers to each other. Therefore, the low melting point metal layer can be heated and fused without influencing the resin substrates and the electronic element, thereby sealing the electronic element.

### Brief Description of the Drawings

Figure 1 is a schematic sectional view of an organic EL display according to a first embodiment of the present invention.
Figure 2 is a collection of schematic views that illustrate the manufacturing steps of the organic EL display of the first embodiment.
Figure 3 is a schematic perspective view that illustrates an irradiating apparatus which is employed to manufacture the organic EL display of the first embodiment.
Figure 4 is a schematic perspective view that illustrates a laser head and a laser module connected to the laser head.
Figure 5 is a graph that illustrates absorption spectra of PEN, PET, Au and Cu.
Figure 6 is a partial schematic sectional view of a sample used in an experiment.
Figure 7 is a schematic sectional view of the sample used in the experiment.
Figure 8 is a collection of photographs obtained through a microscope of the sample after laser irradiation.
Figure 9 is a graph that illustrates temperature increase over time.
Figure 10 is a collection of photographs obtained through a microscope of a sample after laser irradiation.
Figure 11 is a schematic sectional view of a conventional organic EL display.

### Best Mode for Carrying out the Invention

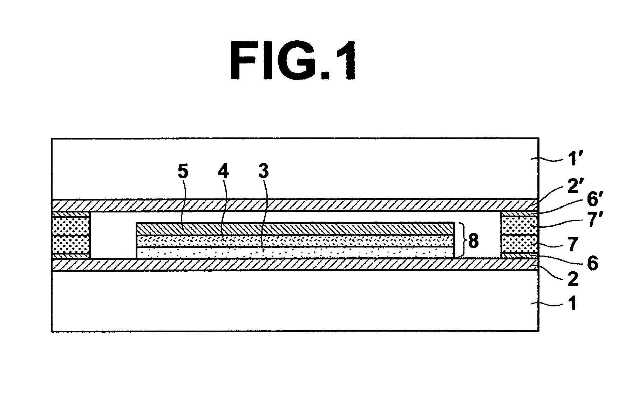

Hereinafter, an electronic device according to an embodiment of the present invention will be described with an organic EL display as an example. Figure 1 is a schematic sectional view of an organic EL display according to a first embodiment of the present invention.

As illustrated in Figure 1, the organic EL display which is illustrated as an embodiment of the present invention is of a structure in which an organic layer is interposed between a plurality of inorganic layers which are provided on a resin substrate 1. The top layer is an inorganic barrier layer 2, on which a transparent electrode 3, the organic layer 4, and an upper electrode 5 are formed as films in this order. The transparent electrode 3, the organic layer 4, and the upper electrode 5 form an organic EL element. A light absorbing layer 6 is provided on the barrier layer 2 at the peripheral portion of the resin substrate 1. A low melting point metal layer 7 is provided directly on the light absorbing layer 6. A light absorbing layer 6' is provided at the peripheral portion of a resin substrate 1', and a low melting point metal layer 7' is provided directly on the light absorbing layer 6. The resin substrate 1 and the resin substrate 1' (the resin substrate 1' is also of a structure in which an organic layer is interposed between a plurality of inorganic layers, similar to the resin substrate 1, and the top layer is an inorganic barrier layer 2') are hermetically sealed at the peripheral portions thereof by the low melting point metal layers 7 and 7'.

Note that in Figure 1, a case is illustrated in which the light absorbing layer 6 is provided between the barrier layer 2 and the low melting point metal layer 7, and the light absorbing layer 6' is provided between the barrier layer 2' and the low melting point metal layer 7'. Alternatively, a light absorbing layer may be provided either between the barrier layer 2 and the low melting point metal layer 7 or between the barrier layer 2' and the low melting point metal layer 7'.

Although not illustrated in Figure 1, extracting electrodes for driving the organic EL element 8 are electrically connected to the transparent electrode 3 and the upper electrode 5, respectively. The extracting electrodes are formed across the sealed peripheral portion and are configured to enable power to be input from the exterior of the electronic device. The extracting electrodes are covered by insulating films such that they are not shorted by the light absorbing layer 6 and the low melting point metal layer 7.

The light absorbing layers 6 and 6' are formed by a material that has an absorption rate with respect to the wavelength of a laser beam irradiated thereon which is capable of increasing the temperature of the light absorbing layers to a degree at which the low melting point metal layers fuse, while suppressing temperature increases of the resin substrates 1 and 1'. Preferred examples of such a material include: Cu; Au; Cr; Mo; and W. In the present embodiment, the light absorbing layers 6 and 6' are metal films having widths of 300µm and thicknesses of 200nm.

The low melting point metal layers 7 and 7' are formed by a metal (including alloys) that have a low melting point (a melting point of less than or equal to 250°C). Preferred examples of such a low melting point metal include: Sn; an Sn/Ag alloy; an Sn/Ag/Cu alloy; an Sn/Ag/Cu/Bi alloy; and In. In the present embodiment, the low melting point metal layers 7 and 7' are indium layers having thicknesses of 5µm.

The barrier layer 2 is provided to suppress passage of moisture and oxygen through the resin substrate, and is of a structure in which an organic layer is interposed between a plurality of inorganic layers. The material of the inorganic layers is selected from a group consisting of: metal oxides; metal nitrides; metal carbides; metal oxide nitrides; metal oxide borides; and combinations thereof. Preferred examples of metal oxides include: silicon oxide; aluminum oxide; titanium oxide; indium oxide; tin oxide; ITO (Indium Tin Oxide); tantalum oxide; zirconium oxide; and niobium oxide. Preferred examples of the material of the organic layer include: polymerizable unsaturated organic materials; polymer products having at least one monomer; cross linked acrylate; low molecular weight addition polymers; natural oils, silicone, and condensed polymers. In the present embodiment, the inorganic layers are formed by silicon oxide nitride, the organic layer is formed by acrylate polymer, and the topmost layer is silicon oxide nitride with a thickness of 3µm.

PEN, PET, PES, PC and the like may be employed as the material of the resin substrate 1 and the resin substrate 1'. In the present embodiment, PEN having a thickness of 100µm is used as the resin substrate 1 and the resin substrate 1'.

Note that regarding the other layers, in the present embodiment, an ITO electrode having a thickness of 100nm is employed as the transparent electrode 3, a positive hole transport layer, a light emitting layer, and an electron transport layer are laminated to from the organic layer 4, and lithium fluoride and aluminum which are stacked in this order are employed as the upper electrode 5. However, the present invention is not limited to this configuration.

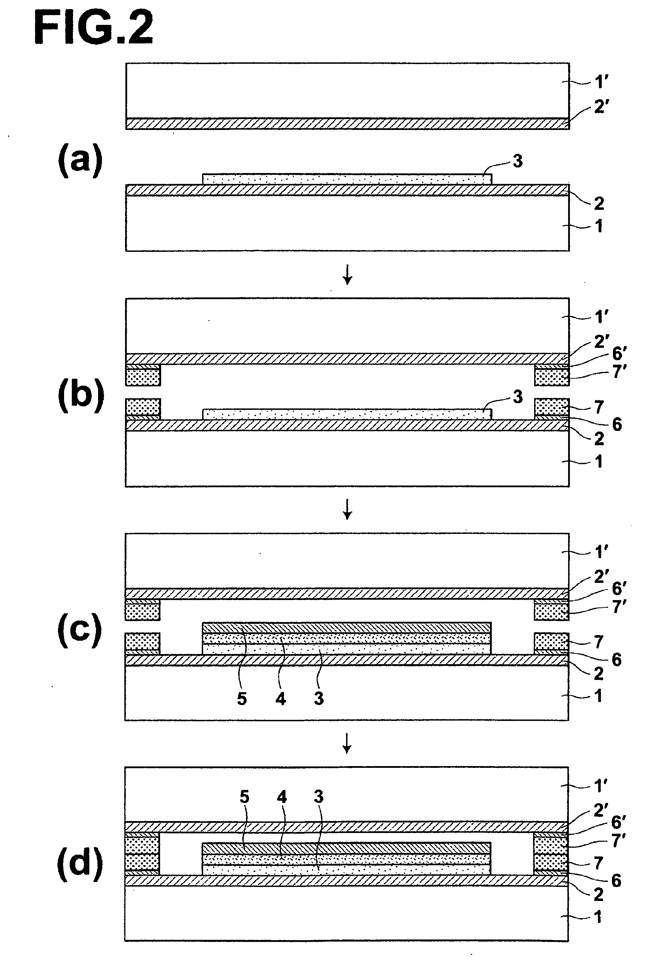

Next, a manufacturing method for the organic EL display, which is an embodiment of the present invention, will be described with reference to Figure 2. First, the barrier layer 2 having the inorganic layer as its topmost layer is formed on the PEN substrate 1. Similarly, the barrier layer 2' having the inorganic layer as its topmost layer is formed on the PEN substrate 1'. Thereafter, the transparent electrode layer 3 is formed on the PEN substrate 1 (Figure 2 (a)). Note that although not shown in Figure 2, extracting electrodes for supplying current to the organic EL element 8 are formed and are covered by insulating films such that they are not shorted by the light absorbing layer 6 and the low melting point metal layer 7.

Next, the light absorbing layers 6 and 6' having widths of 300µm and thicknesses of 200nm are formed on the peripheral portions of the barrier layers 2 and 2' as metal films by vacuum vapor deposition. Portions of the light absorbing layers 6 and 6' are formed on the insulating films. At this time, chrome films having thicknesses of 20nm may be formed at the same widths as the metal film prior to vapor deposition, in order to improve the close contact properties of the light absorbing layers 6 and 6' (metal films) with respect to the topmost inorganic layers of the barrier layers 2 and 2'. Thereafter, indium layers having thicknesses of 5µm are formed at the same portions as those of the light absorbing layers 6 and 6' by vacuum vapor deposition, to form the low melting point metal layers 7 and 7' (Figure 2(b)).

Note that the thickness of the low melting point metal layer 7 and the thickness of the low melting point metal layer 7' may be the same. However, in the case that irradiation of a laser beam to be described later is only performed from the side of the PEN substrate 1', it is possible to decrease the intensity of the laser beam necessary to perform fusing, to decrease the time required for processing, and to suppress the temperature increase in the vicinity of the fused portion, if the low melting point metal layer 7' is formed to have a thickness significantly less than that of the low melting point metal layer 7.

Thereafter, the multilayered organic layer 4 and the upper electrode layer 5 are formed by a process such as vacuum vapor deposition, to form the organic EL element (Figure 2(c)). After forming the organic EL element, the PEN substrate 1' is stacked on the PEN substrate 1 such that the low melting point metal layers 7 and 7' are in contact with each other (Figure 2(d)).

Next, a laser beam is emitted. Note that in the case that the laser beam is irradiated only from the side of the PEN substrate 1', it is possible to provide only the light absorbing layer 6' between the barrier layer 2' and the low melting point metal layer 7', and to not provide the light absorbing layer 6 between the barrier layer 2 and the low melting point metal layer 7.

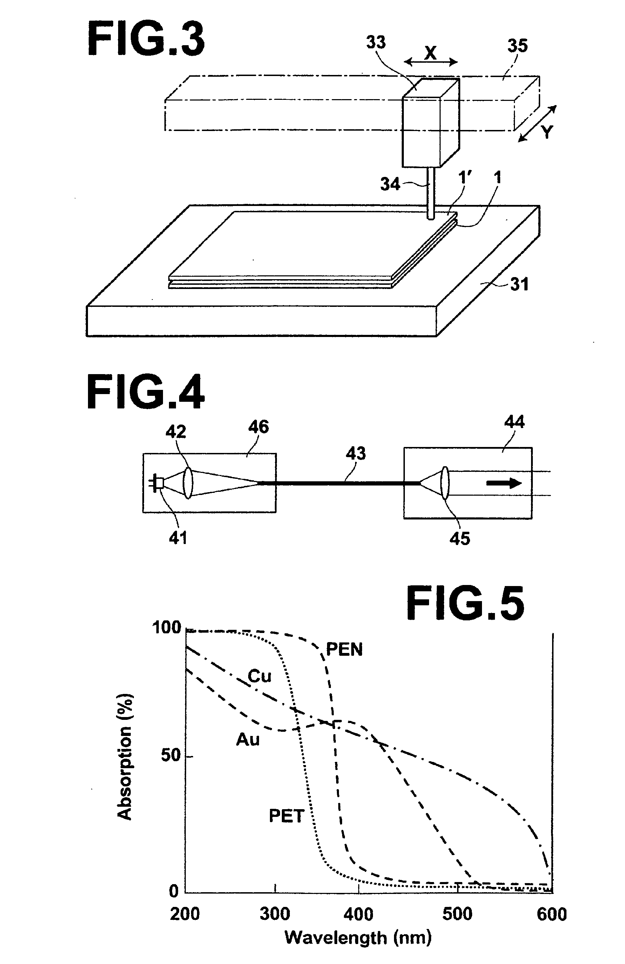

An irradiating apparatus such as that illustrated in Figure 3 is employed to irradiate the laser beam from the side of the PEN substrate 1' such that the laser beam scans the light absorbing layer 6' at the peripheral portion of the PEN substrate 1'. The irradiating apparatus illustrated in Figure 3 is constituted by: a mounting stage 31, on which the PEN substrates 1 and 1' having the light absorbing layers interposed therebetween is placed; a laser head 33, which is provided above the mounting stage 31, for emitting a laser beam 34; and an X-Y moving mechanism 35 for moving the laser head 33 parallel to the mounting stage 31 such that the laser beam 34 is irradiated onto the light absorbing layers.

The X-Y moving mechanism 35 is configured to hold the laser head 33 above the mounting stage 31 and to move the laser head 33 horizontally in the X axis direction and the Y axis direction. The laser beam emitted from the laser head 33 is irradiated through the PEN substrate 1' so as to trace the peripheral portion thereof at which the light absorbing layer 6' is provided. The output of the laser may be 1W, for example, and the scanning speed may be 2m/sec. The output and scanning speed may be freely combined within ranges such that the low melting point metal layers are heated to the point at which they melt and fuse, while the PEN substrates and the barrier layers are not damaged.

The laser beam 34 has a wavelength of 405nm and is collimated into a collimated light beam having a width of 400µm. Therefore, the laser beam 34 is capable of being irradiated across the entire width of the 300µm wide light absorbing layers. A laser module for generating a laser beam as described above will be described. Figure 4 is a schematic perspective view that illustrates a laser head 44 and a laser module 46 connected to the laser head 44 according to an embodiment of the present invention. The laser head 44 is connected to the laser module 46 by an optical fiber 43. The laser module 46 is constituted by a GaN type laser diode that emits a laser beam having a central wavelength of 405nm mounted within a CAN package 41. The light emitted by the GaN type laser diode enters the optical fiber 43, which has a quartz core with a diameter of 60µm, via a lens 42. The optical fiber 43 enters the laser head 44, and the light is collimated into a collimated light beam having a beam diameter of 0.3mm by a collimating lens 45. The optical fiber 43 may be of any desired length, and therefore it is possible to provide the laser module 46 at a distance from the laser head 44. Alternatively, the laser module 46 may be provided within the same housing as the laser head 44, and the housing may be moved by the X-Y moving mechanism.

Note that in the case that the output of a single laser diode does not satisfy a desired laser output level, a plurality of optical fibers may be bundled, or combined light sources may be utilized to increase the laser output from a single laser head.

Next, selection of the wavelength of the laser beam in the present invention will be described. Figure 5 is a graph that illustrates absorption spectra of polyethylene naphthalate (PEN) and polyethylene terephthalate (PET), which are commonly used as materials of substrates for electronic devices, and gold and copper, which are favorably employed as materials for the light absorbing layers. As illustrated in Figure 5, PEN and PET both have absorption edges in the near ultraviolet region. Light having shorter wavelengths is absorbed and not transmitted. The absorption rates of Cu and Au increases as wavelengths become shorter, and a characteristic feature is that the absorption begins from the visible light region.

It is necessary to select a wavelength, with respect to which the resin substrate exhibits sufficiently small absorption, in order to irradiate the laser beam onto the light absorbing layers through the resin substrate. At the same time, it is necessary for the absorption rate of the light absorbing layers with respect to the selected wavelength to be sufficiently high, in order to increase the temperature of the light absorbing layers to a degree that enable the low melting point metal layers to melt, while suppressing the temperature increase of the resin substrates. That is, it is desirable the wavelength of the laser beam to be irradiated to be that at which the absorption rate of the resin substrates and the absorption rate of the light absorbing layer differ by 2x or greater. In the case that PEN is selected as the material of the resin substrates, and the light absorbing layers are formed by gold, suitable wavelengths for the laser beam to be irradiated are within a range from 390nm to 500nm. Similarly, in the case PET and copper are selected, suitable wavelengths for the laser beam to be irradiated are within a range from 350nm to 600nm.

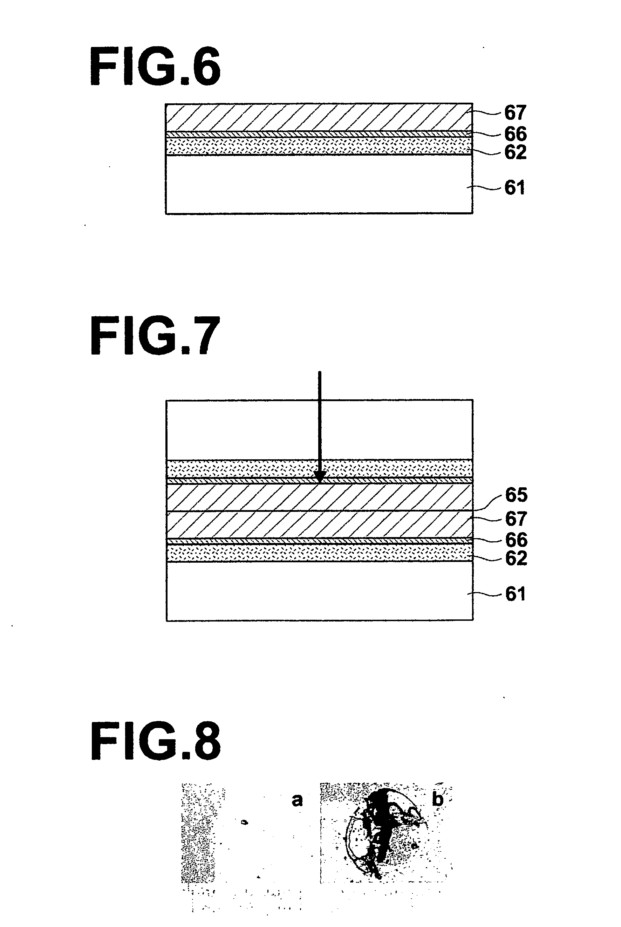

The results of a test experiment, in which PEN was selected as the material of the resin substrates and gold was selected as the material of the light absorbing layers, will be described. A gallium nitride type diode laser that emits a laser beam having a wavelength of 405nm was selected, in view of the aforementioned suitable wavelength ranges. The ratio between the absorption rates of the resin substrate and the light absorbing layer at this wavelength is 1:6. A cross sectional view of a sample which was employed in this experiment is shown in Figure 6. The sample illustrated in Figure 6 is that in which a 3µm thick multilayer barrier layer 62 (having an inorganic layer as the topmost layer) formed by alternately stacking a plurality of inorganic layers and organic layers is formed on a PEN substrate 61. A light absorbing layer 66, constituted by a 20nm thick chrome layer and a 200nm thick Au layer formed by vacuum deposition, is provided on the barrier layer 62. Further, a 5µm thick indium layer is provided on the light absorbing layer 66 as a low melting point metal layer 67. The sample is substantially square, and the length of each side is approximately 25mm.

Two of the samples described above are stacked atop each other such that the low melting point metal layers thereof face each other. The stacked samples are sandwiched between two glass slides, and the glass slides are clamped by two industrial binder clips, to fix the low melting point metal layers with respect to each other under pressure. Then, the laser beam having a wavelength of 405nm was irradiated from the direction of the arrow in Figure 7 through the PEN substrate of the sample.

The barrier layers of the samples are substantially transparent with respect to this wavelength, and absorption thereof by these layers is slight compared to absorption by the light absorbing layers, and therefore absorption by the barrier layers can be ignored. The beam diameter of the irradiated laser beam at the light absorbing layers is approximately 800µm. The laser beam was emitted at an output of 1.3W for one second. Figure 8a is a photograph obtained through a microscope from the direction of the arrow in Figure 7 after irradiating the laser. The light colored circle within Figure 8a substantially corresponds to the beam diameter of the laser beam. At this portion, some discoloration can be observed due to the improvement in close contact properties between the PEN substrate and the barrier layer. However, there is change in the layer structure, and it can be understood that no damage has occurred at the barrier layer. Figure 8b is a photograph of the surface of the low melting point metal layer at the same position obtained through a microscope. As is clear from Figure 8b, evidence that the low melting point metal layer has fused and coupled at the same diameter as the discolored portion of the upper surface can be seen.

Next, a thermocouple was placed at a coupling surface 65 between the low melting point metal layers illustrated in Figure 7, and the same laser beam irradiation as that described above was performed such that the laser beam was irradiated on the light absorbing layer directly above the thermocouple. Figure 9 is a graph that illustrates the manner in which temperature increased over time. The vertical axis of the graph represents the temperature of the low melting point metal layers, and the horizontal axis represents time from initiation of laser beam irradiation. The temperature of the low melting point metal layers increases immediately following initiation of laser beam irradiation, and exceeds the melting point of the indium low melting point metal layers (175°C) after approximately 0.5 seconds. A temperature of approximately 175°C is reached after one second. Combined with the aforementioned experimental results, it can be understood that if a laser beam having a beam diameter of 800µm and an output of 1.3W is irradiated for one second, a temperature sufficient to melt and fuse indium (175°C) is reached, and that damage to the PEN substrate and the barrier layers does not occur at this temperature.

An experiment in which the laser beam was scanned was administered onto the same samples as those illustrated in Figure 7. The beam diameter of the laser beam was 400µm, the output of the laser beam was 980mW, and the scanning speed was 2mm/sec. Figure 10 is a collection of photographs of the surface a of a PEN substrate toward the side through which the laser beam was irradiated, the surface b of an upper low melting point metal layer, the surface c of a lower low melting point metal layer, and the surface d of a lower PEN substrate, obtained through a microscope of a sample after laser irradiation. Linear coupling marks can be observed on the surface of the two lowmelting point metal layers which are coupled to each other, but no changes can be observed on either of the two surface a and d of the PEN substrates.

From the above results, it was proven that low melting point metal layers can be heated and fused to seal an electronic element without influencing resin substrates, barrier layers, or the electronic element, by selecting appropriate irradiation conditions.

The present embodiment has been described as a case in which an organic EL element was employed as the electronic element. However, the sealing structure and the sealing method of the present invention are not limited to such a configuration. The present invention may be applied to seal display media such as liquid crystal, sensors formed by organic substances, imaging elements, electronic circuits, and other electronic elements formed by organic substances as electronic elements to be sealed.

## Claims

1. An electronic device, comprising:
a pair of resin substrates;
barrier layers laminated on each of the pair of resin substrates;
an electronic element formed on one of the barrier layers;
low melting point metal layers for bonding the pair of resin substrates together, provided at the peripheries of the barrier layers so as to surround the electronic element; and
a light absorbing layer provided between at least one of the barrier layers and one of the low melting point metal layers.

2. An electronic device as defined in Claim 1, wherein:
the electronic element includes organic materials.

3. A method for manufacturing an electronic device, in which a low melting point metal layer is provided to seal an electronic element between a pair of resin substrates each having a barrier layer laminated thereon, and the low melting point layer bonds the barrier layers of the resin substrates to each other, comprising the steps of:
providing a light absorbing layer between at least one of the barrier layers and the low melting point metal layer; and
irradiating a laser beam having a wavelength within a range from 350nm to 600nm onto the light absorbing layer through at least one of the resin substrates and the barrier layer laminated thereon, to heat and fuse the low melting point metal layer, thereby bonding the barrier layers to each other.

4. An electronic device as defined in Claim 3, wherein:
the electronic element includes organic materials.
